Europäisches Patentamt

European Patent Office

Office européen des brevets

(19)

(11) Numéro de publication : **0 011 694**
**B1**

(12) **FASCICULE DE BREVET EUROPÉEN**

(45) Date de publication du fascicule du brevet :
15.12.82

(21) Numéro de dépôt : **79103772.4**

(22) Date de dépôt : **03.10.79**

(51) Int. Cl.³ : **H 01 L 23/56//** H03F1/30,
H03K17/14

(54) Procédé et dispositif d'ajustement réversible des paramètres électriques d'un circuit électrique.

(30) Priorité : **29.11.78 US 964323**

(43) Date de publication de la demande :
**11.06.80 (Bulletin 80/12)**

(45) Mention de la délivrance du brevet :
**15.12.82 Bulletin 82/50**

(84) Etats contractants désignés :
**DE FR GB**

(56) Documents cités :
**DE A 2 827 165**
**IBM TECHNICAL DISCLOSURE BULLETIN**
**Vol. 20, No. 11 A, Avril 1978 New York**
**L.D. LARSEN et al. « Floating element field-effect**
**device » pages 4 518 à 4 521.**
**IEEE JOURNAL OF SOLID-STATE CIRCUITS, Vol.**
**SC-12, No. 5, Octobre 1977 New York**
**R.G. MÜLLER et al. « An 8192-Bit Electrically**
**Alterable ROM Employing a One-Transistor Cell**
**with Floating Gate » pages 507 à 514.**

(73) Titulaire : **International Business Machines Corporation**
**Armonk, N.Y. 10504 (US)**

(72) Inventeur : **Hoffman, Charles Reeves**
**1537 Shadowood Ln.**
**Raleigh NC 27612 (US)**

(74) Mandataire : **Colas, Alain**
**COMPAGNIE IBM FRANCE Département de Propriété**
**Industrielle**
**F-06610 La Gaude (FR)**

Jouve, 18, rue St-Denis, 75001 Paris, France

Procédé et dispositif d'ajustement réversible des paramètres électriques d'un circuit électrique

### Description

### Domaine technique

La présente invention concerne d'une façon générale le domaine de la fabrication des circuits intégrés à semi-conducteurs et, plus particulièrement, un procédé et un dispositif permettant d'ajuster les paramètres d'un circuit électrique comportant des transistors à effet de champ.

### Etat de la technique antérieure

Un problème qui se pose lors de la conception et de la fabrication des divers éléments intégrés à un substrat semi-conducteur concerne l'uniformité des niveaux de tension afférents à ces éléments. De nombreux problèmes, notamment les niveaux de tension décalés des amplificateurs opérationnels, la linéarité des circuits de conversion numérique/analogique, les niveaux de seuil variables dans les circuits de commutation et d'enclenchement, etc., viennent du fait que, lors de la création sur le substrat des différents éléments d'un circuit donné, il se produit de très faibles variations de dimensions, de la conductivité, etc., qui ont pour effet de créer, dans les dispositifs, de nombreux points fonctionnant à des tensions légèrement différentes. Diverses techniques sont employées pour ajuster les tensions de fonctionnement des différents éléments du substrat semi-conducteur de manière à améliorer la performance globale du circuit. Ces techniques utilisent, notamment, des résistances variables, qui peuvent être décapées chimiquement ou au moyen d'un laser, des fusibles métalliques que l'on peut découper au moyen d'un laser, etc., ou un ensemble de diodes zener que l'on peut court-circuiter ou connecter de façon sélective, etc. D'autres techniques analogues consistent à faire varier la région active d'une résistance, ou à réduire une capacité active par décapage d'une électrode capacitive, etc.

Des exemples de ces techniques d'ajustement sont décrites dans l'article de J. J. Price et al. intitulé « A Precision Slope Polarity Switch for a Monolithic Telephone Quality Delta Modulator », dans l'article de Fredericksen et al. intitulé « A Single Chip, All Bipolar, Camera Control I. C. » et dans l'article de D.T. Comer intitulé « A Moniiithic Twelve Bit D/A Converter » respectivement parus dans la publication intitulée « ISSCC Digest of Technical Papers », 1977, page 6 061, pages 214-215 et pages 104-105.

Une difficulté que posent les techniques d'ajustement de l'art antérieur qui sont utilisées dans le domaine des circuits intégrés réside dans le fait qu'elles ne sont pas réversibles au sens habituel du terme. Une fois que le lien actif a été rompu, comme cela se produit quand on court-circuite les conducteurs d'une diode zener, lors du retrait d'un matériau résistif ou lors d'autres opérations analogues, le paramètre commandé par la variation de cet élément ne peut pas être modifié dans la direction opposée. D'autre part, le paramètre que l'on ajuste au moyen d'une technique de décapage par laser ou de découpage de fusibles métalliques doit être contrôlé avec soin de manière à obtenir la précision désirée lors de la phase finale de l'ajustement. Il s'agit là d'une opération longue et coûteuse, particulièrement lorsqu'elle est effectuée sur une très petite surface d'un bloc de circuits intégrés.

### Exposé de l'invention

L'un des objets de la présente invention est donc de fournir un procédé et un dispositif d'ajustement que l'on puisse faire varier électriquement et qui soit réversible.

La présente invention permet notamment d'atteindre l'objectif ci-dessus en créant sur le bloc de circuits intégrés au moins un transistor à effet de champ à porte flottante, laquelle est connectée à la porte d'au moins un autre transistor à effet de champ dont la porte fonctionne à la tension à laquelle la porte flottante du premier transistor est chargée. Pour charger ou décharger ladite porte flottante, on applique des tensions appropriées à la porte de commande ainsi qu'à la source et au drain du dispositif, de façon classique. La charge ou la tension résultante qui apparaît sur la porte flottante du transistor peut être considérée comme étant électriquement permanente jusqu'à ce que son état de charge soit modifié électriquement en appliquant de nouvelles tensions à la source, au drain et à la porte de commande du dispositif, au gré de l'utilisateur. Un conducteur électrique permet d'appliquer la tension, présente au niveau de la porte flottante, à la porte d'un transistor à effet de champ (FET) actif de manière à modifier l'état de conduction de ce dernier, ce qui est un mode de fonctionnement normal pour les dispositifs de ce type. Le transistor FET actif peut faire partie d'un circuit analogique ou numérique dans lequel on doit faire varier le paramètre de courant ou de tension en faisant varier la conduction du transistor FET lui-même. Ce résultat est obtenu en faisant varier la tension appliquée à sa porte de commande, et celle-ci est fonction de la tension variable que conserve la porte flottante du transistor FET initial.

D'autres objets, caractéristiques et avantages de la présente invention ressortiront mieux de l'exposé qui suit, fait en référence aux dessins annexés à ce texte, qui représentent un mode de réalisation préféré de celle-ci.

### Brève description des figures

La Figure 1 représente schématiquement une coupe d'un transistor FET à porte flottante du type classique qui est utilisable dans la présente invention.

La Figure 2 représente schématiquement un circuit électrique permettant de connecter un transistor FET à porte flottante à la porte de commande d'un transistor FET actif dont la conduction doit être ajustée électriquement.

La Figure 3 est une vue schématique simplifiée du transistor FET à porte flottante et d'un transistor FET actif distinct du premier et dont on doit faire varier la conduction, ainsi que des conducteurs qui transmettent la charge emmagasinée dans ladite porte flottante à la porte de commande du dispositif FET actif.

La Figure 4 est un schéma électrique analogue à celui de la Figure 2, mais qui montre les effets des diverses capacités créées entre lesdites portes, les isolants et les substrats des deux dispositifs FET ainsi que l'effet de la capacité de shunt entre le connecteur et le substrat.

La Figure 5 représente schématiquement une variante de l'invention.

Mode de réalisations préférées

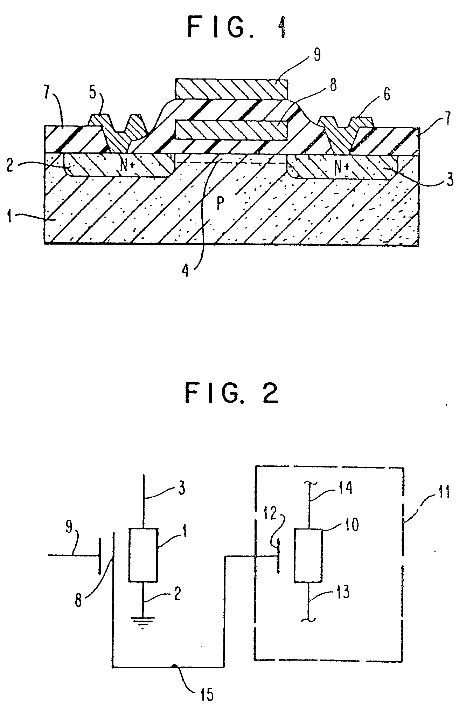

On a représenté sur la Figure 1 une coupe longitudinale d'un transistor FET à porte flottante et à canal N. Les transistors de ce type étant bien connus, on ne donnera ci-après qu'une brève description du dispositif typique représenté sur la Figure 1. Un substrat semi-conducteur 1, qui est en l'occurrence du silicium de type P, comporte une source 2 et un drain 3 dopés au moyen d'une impureté de type N. Un canal conducteur 4 relie la source 2 et le drain 3 et peut être créé, de façon classique, soit par dopage, soit par appauvrissement au moyen de l'application d'une tension de commande à une porte. La source et le drain sont respectivement pourvus de contacts 5 et 6. Ces derniers traversent une couche isolante sus-jacente 7 en dioxyde de silicium. Le dispositif comporte une porte flottante 8 en polysilicium conducteur qui est complètement entourée par la couche isolante 8. Une porte de commande 9 en polysilicium ou en métal recouvre la porte flottante 8 dont elle est séparée par la couche isolante 7. La réalisation et le fonctionnement de tels dispositifs sont bien connus. Par exemple, le brevet des E.U.A. No. 3 955 098 décrit des dispositifs de ce type dans lesquels la porte flottante est chargée pour atteindre le potentiel désiré de manière à créer un niveau élevé de conduction dans le canal ; plus particulièrement, les tensions de porte étant plus élevées que celles fournies par l'alimentation à laquelle les semi-conducteurs sont connectés, ces derniers sont portés à saturation. Toutefois, ledit brevet ne fait aucune allusion à l'emploi du dispositif à porte flottante pour fixer le niveau de tension, appliqué à une porte de commande, à une valeur comprise dans la plage des tensions d'alimentation appliquées au transistor actif qui comporte cette porte de commande, et ce, afin d'ajuster le niveau de tension de fonctionnement du transistor FET actif comme décrit dans la présente invention. Ce brevet ne mentionne pas l'application du potentiel emmagasiné de la porte flottante à la porte de commande d'un transistor FET actif dans un circuit dont les paramètres de conduction doivent être ajustés, car la technique décrite dans ledit brevet consiste uniquement à créer une polarisation de saturation pour obtenir des excursions de tension importantes dans un circuit de commutation, et non pour obtenir et maintenir une correspondance précise de la tension ou du courant, comme cela est nécessaire lors d'une opération d'ajustement effectuée dans les limites de la tension d'alimentation ordinaire appliquée au circuit que l'on désire ajuster. Le dispositif décrit dans ce brevet peut être utilisé dans la présente invention en faisant en sorte que le transistor FET commandé fasse partie du circuit actif dont les paramètres doivent être ajustés et en appliquant au transistor à porte flottante des tensions programmables que l'on peut faire varier et que l'on supprime une fois que les paramètres de sortie du dispositif commandé ont atteint leur valeur optimum, la porte flottante restant ensuite chargée au potentiel optimum désiré de telle sorte que le transistor FET ajusté puisse atteindre son point de fonctionnement optimum. Cela diffère radicalement des techniques et des dispositifs d'ajustement normalement employés étant donné qu'aucune résistance ou capacité variable n'est nécessaire ou ne doit être connectée de manière à commander l'état du dispositif actif, qu'aucune technique spécialisée de décapage au laser ou de fusion n'est nécessaire, et que l'on n'emploie aucun écran de précision pour le matériau résistif. De même, il ne faut, à la surface du bloc semiconducteur, que le minimum de place requis aux fins de la mise en place de deux transistors, ce qui permet d'augmenter la densité des circuits actifs.

On a schématiquement représenté sur la Figure 2 un circuit fonctionnel utilisant le procédé et le dispositif d'ajustement de la présente invention. Sur la Figure 2, la seconde couche de polysilicium 9 qui recouvre la porte flottante 8 du transistor FET 1 pourvu d'une source 2 et d'un drain 3 constitue la porte de commande de ce transistor. C'est à cette porte de commande 9 que sont appliquées les tensions programmées précédemment mentionnées qui peuvent être sensiblement supérieures à celles normalement employées pour charger la porte flottante 8 à différents niveaux. Ces niveaux de tensions sont appliqués par l'intermédiaire d'un conducteur 15, qui peut être une extension de la première couche de polysilicium constituant la porte 8, à la porte de commande 12 du transistor actif 10 comportant une source 13 et un drain 14 et faisant partie d'un circuit fonctionnel 11 dont on désire ajuster les paramètres. Un choix judicieux des tensions de drain et de porte du transistor 1 permet de fixer la charge de la porte flottante 8 à la valeur requise pour obtenir le point de fonctionnement désiré du transistor 10, après quoi

ces tensions cessent d'être appliquées au transistor 1 et la porte flottante 8 reste chargée à ce potentiel désiré.

Il existe de nombreuses applications de ce dispositif et de ce procédé d'ajustement. Il pourrait s'agir, par exemple, d'une source programmable de tensions de référence dans laquelle le transistor FET actif 10 ferait partie d'un amplificateur opérationnel, la porte flottante 8 du transistor FET à porte flottante étant maintenue à un niveau de référence programmé. De même, l'invention pourrait être employée sous la forme d'un détecteur de seuil dans lequel le niveau de tension appliqué au transistor FET à porte flottante programmerait un niveau de référence de seuil destiné à être comparé avec la tension d'entrée appliquée au circuit actif 11 de la Figure 2. L'invention permet d'effectuer l'ajustement de la fréquence d'un oscillateur de même que tous les divers types d'ajustement mentionnés dans les trois articles précités.

Aux fins de la mise en œuvre de la présente invention, on emploiera de préférence une technologie permettant de réaliser des transistors FET à porte flottante et des transistors FET normaux sur un même bloc. Divers procédés permettant d'atteindre ce résultat sont bien connus. A cet égard, on se reportera, par exemple, aux articles de Mueller et al. et de Rodgers et al. respectivement parus dans la publication « IEEE Journal of Solid State Circuits », Vol. SC-12, No. 5, Octobre 1977, pages 507-514 et 515-523, ou à l'article de Barnes et al. paru dans la publication « Solid State Electronics », Vol. 21, 1978, pages 521-529, articles dans lesquels on trouvera une description de diverses techniques et de différents dispositifs qui peuvent aisément être employés dans la présente invention.

Les articles de Mueller et al. et de Barnes et al. décrivent des structures planar, cependant que l'article de Rodgers et al. traite d'une structure VMOS différente. Il n'existe donc pas de procédé unique permettant de réaliser le dispositif de la présente invention, mais un grand nombre de procédés connus dont certains sont décrits dans les références ci-dessus.

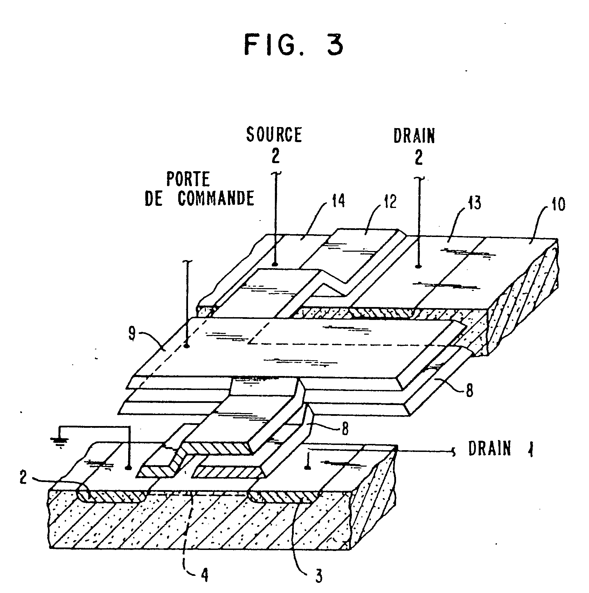

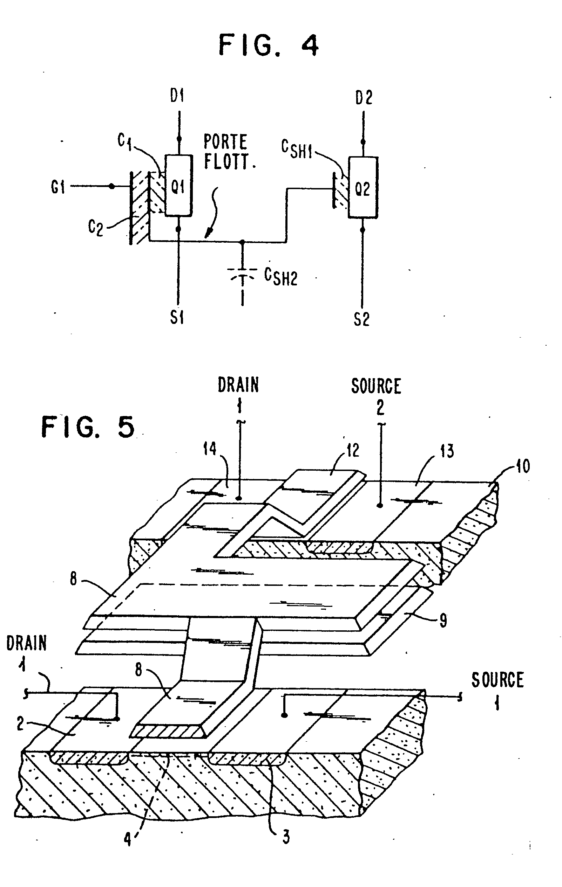

Toutefois, dans la présente invention, la porte flottante 8 peut être prolongée de telle sorte qu'elle puisse constituer la porte d'un transistor FET normal, ainsi qu'on l'a représentée à titre d'exemple sur la Figure 3. A cet égard, le couplage de la porte de commande 9 à la porte flottante 8 constitue un élément essentiel pour le fonctionnement de la présente invention. Ainsi qu'il ressort de la Figure 3, les couches de polysilicium 8 et 9, qui constituent respectivement la porte flottante et la porte de commande, peuvent être considérées comme formant les plaques d'un condensateur, la couche d'oxyde (non représentée sur la Figure 3 dans un but de clarté) qui les sépare étant le matériau diélectrique. Le circuit électrique correspondant à cet agencement est représenté schématiquement sur la Figure 4.

On observera sur la Figure 4 que plusieurs capacités sont formées entre les portes en polysilicium et le substrat. La capacité $C_1$ est celle formée entre la porte flottante 8 et le canal du transistor FET à porte flottante. La capacité $C_2$ est celle formée entre la porte de commande 9 et la porte flottante 8. Il existe également certaines capacités de shunt qui tendent à affecter les capacités $C_1$ et $C_2$ et qui sont les suivantes. La capacité de shunt $C_{SH1}$ correspond à la région située au-dessous de la porte et qui recouvre le canal du transistor FET commandé. La capacité de shunt $C_{SH2}$ est celle formée au-dessous de la partie du matériau constituant la porte flottante qui ne se trouve pas au-dessus de l'un ou de l'autre des deux transistors, mais qui est comprise entre ceux-ci, ainsi qu'on l'a représenté sur la Figure 3 à titre d'exemple.

On sait que la capacité formée entre la porte de commande 9 et la porte flottante 8 doit être importante par rapport à celle formée entre la porte flottante et le canal, comme indiqué dans les articles précités de Rodgers et al.et de Mueller et al. Lorsqu'on prolonge la porte flottante de telle sorte que celle-ci puisse former la porte de commande d'un transistor FET normal, il convient de tenir compte des effets de la capacité supplémentaire qui est alors formée. Afin de compenser la capacité de shunt qui résulte de cette prolongation de la porte flottante, il est indispensable d'augmenter en conséquence la région de la capacité qui est formée par les couches de polysilicium. C'est ce qu'on a représenté sur la Figure 3, sur laquelle les extensions de la porte de commande en polysilicium 9 et de la porte flottante en polysilicium 8 se recouvrent mutuellement dans la région située entre les canaux des deux transistors.

La capacité de shunt représentée sur la Figure 4 peut être réduite au minimum en utilisant la couche de polysilicium 9 comme une porte flottante, ainsi que le montre la Figure 5. Etant donné que la porte 9 se trouve physiquement au-dessous de la porte flottante 8 sur la Figure 5, l'une des capacités de shunt, $C_{SH2}$, est effectivement supprimée. Cet agencement occupe moins de place à la surface du bloc semiconducteur tout en permettant d'obtenir le couplage requis entre la porte de commande et la porte flottante.

Ainsi que le comprendra l'homme de l'art, la présente invention peut être réalisée au moyen de divers matériaux et procédés bien connus et permet d'obtenir une structure susceptible d'être fabriquée sur le même bloc que plusieurs autres transistors FET de façon à présenter une densité élevée. L'invention permet de procéder rapidement à l'ajustement électronique des divers paramètres des circuits par l'intermédiaire de broches externes du type normalement utilisé dans les ensembles de blocs électroniques de ce type. Cela constitue un avantage très important car il permet d'éviter l'emploi de techniques soustractives de haute précision, par exemple le décapage par laser, de même que le court-circuitage de diodes ou la mise en circuit ouvert de connexions électriques que l'on utilise habituellement dans le cadre des opérations d'ajustement actuelles.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Dispositif d'ajustement réversible et électriquement altérable des paramètres de conduction actifs, d'un circuit électrique, caractérisé en ce qu'il comprend :

un premier transistor FET (1) du type à porte flottante (8), comportant, outre cette dernière, une source (2), un drain (3) et une porte de commande (9),

un second transistor FET (10) comportant une source (13), un drain (14) et une porte de commande (12), et connecté à un circuit (11) dont un paramètre de conduction doit être ajusté, et

des moyens électriquement conducteurs (15) pour connecter la porte flottante (8) dudit premier transistor FET à la porte de commande (12) dudit second transistor FET, permettant ainsi d'appliquer le niveau de tension de ladite porte flottante (8) à ladite porte de commande (9) et de commander le niveau de conduction de courant dans ledit second transistor FET (10) et dans le circuit (11) auquel il est connecté.

2. Dispositif selon la revendication 1, caractérisé en ce que lesdits moyens électriquement conducteurs (15) qui relient lesdites portes sont une prolongation du matériau constituant ladite porte flottante (8) et font partie intégrante de celle-ci.

3. Dispositif selon l'une des revendications 1 ou 2, caractérisé en ce que lesdits moyens électriquement conducteurs qui relient lesdites portes comportent une capacité (C2) définie par la porte de commande (9) et la porte flottante (8) dudit premier transistor FET (1), cette capacité étant plus importante que celle qui existe entre la porte flottante (8) et le substrat du premier transistor FET.

4. Procédé pour ajuster de façon réversible et électriquement altérable les paramètres de conduction d'un circuit électrique, caractérisé en ce qu'il comporte les étapes suivantes :

charger, à un niveau de tension prédéterminé, la porte flottante (8) d'un premier transistor à effet de champ (1) comportant en outre une porte de commande (9), un drain (3) et une source (2), ledit niveau de tension étant obtenu par l'application de tensions programmables au drain (3) et à la porte de commande (9) du premier transistor à effet de champ,

connecter ledit niveau de tension de la porte flottante (8) à la porte de commande (12) d'un second transistor à effet de champ (10) faisant partie d'un circuit (11) dont les paramètres de conduction doivent être ajustés, la valeur dudit niveau de tension étant définie comme celle qui permet d'obtenir le point de fonctionnement désiré du deuxième transistor à effet de champ (10) et, lesdites tensions programmables cessant d'être appliquées au premier transistor à effet de champ (1) et la porte flottante (8) restant alors chargée audit niveau de tension dès que ledit point de fonctionnement est atteint,

contrôler la conduction du second transistor à effet de champ (10) en agissant sur le niveau de tension de la porte flottante (8) du premier transistor à effet de champ (1), l'ajustement des paramètres de conduction du circuit étant déterminé par la conduction du second transistor à effet de champ.

## Claims

1. A device for adjusting, in a reversible and electrically alterable manner, the active conduction parameters of an electric circuit, characterized in that it includes :

a first FET transistor (1) of the floating gate (8) type comprising, in addition to the latter a source (2), a drain (3), and a control gate (9),

a second FET transistor (10) comprising a source (13), a drain (14) and a control gate (12), and being connected to a circuit (11), one parameter of which is to be adjusted, and

electrically conducting means (15) for connecting the floating gate (8) of said first FET transistor to the control gate (12) of said second FET transistor, thereby applying the voltage level of said floating gate (8) to said control gate (9) and controlling the current conduction level in said second FET transistor (10) and in the circuit (11) to which it is connected.

2. A device according to claim 1, characterized in that said electrically conducting means (15) interconnecting said gates are an extension of the material forming said floating gate (8) and are part thereof.

3. A device according to claim 1 or 2, characterized in that said electrically conducting means interconnecting said gates comprise a capacitance (C2) defined by the control gate (9) and the floating gate (8) of said first FET transistor (1), said capacitance being higher than that present between the floating gate (8) and the substrate of the first FET transistor.

4. A method for adjusting, in a reversible and electrically alterable manner, the conduction parameters of an electric circuit, characterized in that it comprises the steps of :

charging to a predetermined voltage level the floating gate (8) of a first FET transistor (1) having in addition to said gate a control gate (9), a drain (3) and a source (2), said voltage level being obtained by applying programmable voltages to the drain (3) and to the control gate (9) of the first FET transistor,

connecting said voltage level of the floating gate (8) to the control gate (12) of a second FET transistor (10) that is part of a circuit (11) whose conduction parameters are to be adjusted, the value of said voltage level being defined so as to obtain the desired operation point of the second FET transistor (10), said programmable voltages being no longer applied to the first FET transistor (1), and the floating gate (8) charge remaining at said voltage level when said operation point is reached,

controlling the conduction of the second FET transistor (10) by controlling the voltage level of the floating gate (8) of the first FET transistor (1), the adjustment of the conduction parameters of the circuit being determined by the conduction of the second FET transistor.

**Ansprüche**

1. Vorrichtung zum umkehrbaren und elektrisch veränderlichen Einstellen der aktiven Durchlaßparameter einer elektrischen Schaltung, dadurch gekennzeichnet, daß sie einschließt :

einen ersten FET Transistor (1) mit schwebender Gateelektrode (8), welcher außerdem eine Sourceelektrode (2), eine Drainelektrode (3) und ein Steuergate (9) aufweist, einen zweiten FET Transistor (10), welcher eine Sourceelektrode (13), eine Drainelektrode (14) und ein Steuergate (12) aufweist, und mit einer Schaltung (11) verbunden ist, von der ein Durchlaßparameter eingestellt werden soll, und

elektrisch leitende Mittel (15) zum Verbinden der schwebenden Gateelektrode (8) des ersten FET Transistors mit dem Steuergate (12) des zweiten FET Transistors, so daß der Spannungspegel der schwebenden Gateelektrode (8) an das Steuergate (9) angelegt und der Stromdurchlaßpegel im zweiten FET Transistor (10) und in der damit verbundenen Schaltung (11) gesteuert werden kann.

2. Vorrichtung nach Anspruch 1, dadurch gekennzeichnet, daß die elektrisch leitenden Mittel (15), die diese Gates verbinden, eine Verlängerung des die schwebende Gateelektrode (8) bildenden Materials darstellen und ein Teil davon sind.

3. Vorrichtung nach Anspruch 1 oder 2, dadurch gekennzeichnet, daß die elektrisch leitenden Mittel, welche die Gates verbinden, eine Kapazität (C2) aufweisen, die vom Steuergate (9) und der schwebenden Gateelektrode (8) des ersten FET Transistors (1) bestimmt wird, wobei diese Kapazität größer ist, als die zwischen der schwebenden Gateelektrode (8) und dem Substrat des ersten FET Transistors liegende.

4. Verfahren zum umkehrbaren und elektrisch veränderlichen Einstellen der Durchlaßparameter einer elektrischen Schaltung, dadurch gekennzeichnet, daß es folgende Verfahrensschritte einschließt :

Laden auf einen vorbestimmten Spannungspegel der schwebenden Gateelektrode (8) eines ersten FET Transistors (1), der außer diesem ein Steuergate (9), eine Drainelektrode (3) und eine Sourceelektrode (2) aufweist, wobei der Spannungspegel durch Anlegen programmierbarer Spannungen an die Drainelektrode (3) und an das Steuergate (9) des ersten FET Transistors erhalten wird,

Verbinden des Spannungspegels der schwebenden Gateelektrode (8) mit dem Steuergate (12) eines zweiten FET Transistors (10), der einer Schaltung (11) angehört, deren Durchlaßparameter einzustellen sind, wobei die Höhe des Spannungspegels so bestimmt wird, daß man den gewünschten Arbeitspunkt des zweiten FET Transistors (10) erhält, und wobei, wenn die programmierbaren Spannungen nicht mehr an den ersten FET Transistor (1) angelegt werden, die schwebende Gateelektrode (8) auf dem Spannungspegel geladen bleibt, sobald der Betriebspunkt erreicht ist, und

Steuern der Leitfähigkeit des zweiten FET Transistors (10) durch Einwirken auf den Spannungspegel der schwebenden Gateelektrode (8) des ersten FET Transistors (1), wobei das Einstellen der Durchlaßparameter der Schaltung von der Leitfähigkeit des zweiten FET Transistors bestimmt wird.

# FIG. 1

# FIG. 2

# FIG. 3

PORTE
DE COMMANDE

SOURCE
2

DRAIN
2

14  12  13  10

9

8

8

2

DRAIN 1

4  3

# FIG. 4

D1              D2

$C_1$

PORTE
FLOTT.

$C_{SH1}$

G1

$C_2$

Q1

Q2

$C_{SH2}$

S1              S2

# FIG. 5

DRAIN        SOURCE

14      12     13     10

8              9

DRAIN

8

SOURCE

2

4      3